Europäisches Patentamt

European Patent Office

Office européen des brevets

(11) Publication number: **0 049 872**
**B1**

# EUROPEAN PATENT SPECIFICATION

(45) Date of publication of patent specification: **25.09.85**

(51) Int. Cl.⁴: **H 01 J 3/12,** H 01 J 37/304

(21) Application number: **81108089.4**

(22) Date of filing: **08.10.81**

(54) **Electron beam exposure system.**

(30) Priority: **15.10.80 JP 143946/80**
**23.10.80 JP 148693/80**

(43) Date of publication of application:
**21.04.82 Bulletin 82/16**

(45) Publication of the grant of the patent:
**25.09.85 Bulletin 85/39**

(84) Designated Contracting States:
**DE FR GB**

(56) References cited:
**DE-A-2 731 142**
**GB-A-2 007 394**
**US-A-3 576 438**
**US-A-3 644 700**
**US-A-3 900 736**
**US-A-4 020 343**

**ELEKTRONIK, Heft 8, August 1977, Franzis-Verlag, München, T.H.P. CHANG, M. HATZAKIS, A.D. WILSON, A.J. SPETH, A. KERN "Grundlagen und Technik der Elektronenstrahl-Lithografie" pages 51-60**

(73) Proprietor: **Kabushiki Kaisha Toshiba**
**72, Horikawa-cho Saiwai-ku**
**Kawasaki-shi Kanagawa-ken 210 (JP)**

(72) Inventor: **Nakasuji, Mamoru**
**2-15-11 Serigaya**
**Konan-ku Yokohama-shi (JP)**
Inventor: **Wada, Hirotsugu**
**2-12-3 Tamagawagakuen**
**Machida-shi Tokyo (JP)**

(74) Representative: **Henkel, Feiler, Hänzel & Partner**
**Möhlstrasse 37**
**D-8000 München 80 (DE)**

(56) References cited:

**IBM JOURNAL OF RESEARCH AND DEVELOPMENT, vol. 21, no. 6, November 1977, New York D.E. DAVIS, R.D. MOORE, M.C. WILLIAMS, O.C. WOODARD "Automatic registration in an electron-beam lithographic system" pages 498-505**

Courier Press, Leamington Spa, England.

# Description

The present invention relates to an electron beam exposure system in which the deviation of the electron beam path caused by an axial shift of the first cross-over of the electron beam is corrected.

Electron beam exposure systems with which the shape and the size of an electron beam spot can be varied have recently received a lot of attention. In these exposure systems, the electron beam is projected through a first electron beam shaping aperture to form a first aperture image which is, in turn, projected through a second electron beam shaping aperture, so that an electron beam spot formed by overlap of both aperture images is formed on a target. The overlap of the two aperture images can be varied by deflecting the first aperture image. Therefore, the shape and the size of the electron beam spot can be varied according to the degree of deflection.

When in an electron beam exposure system of this type the cross-over position of the electron beam drifts, it may be that the target is not exposed with the desired electron beam spot, and it may occur that a correct circuit pattern is not formed. When the cross-over position drifts in the direction perpendicular to the axis of the electron optical column of the system, the axis of the electron optical column and the electron beam path are misaligned, and the electron lens exposure system becomes incapable of controlling correctly the electron beam.

To obviate these shortcomings, an electron beam exposure system has been proposed which comprises a servo controller for correcting the deviation of the electron beam path caused by the drift of the cross-over position in the direction perpendicular to the axis of the electron optical column. In this electron beam exposure system, a faraday cup is arranged in the optical column, the current of the electron beam passing through an aperture disposed at the cross-over position is detected by the faraday cup, and alignment coils arranged at the other cross-over position are so servocontrolled that the electron beam current thus measured is maximized, thereby maintaining the magnification of the cross-over image at the position of the coil at substantially the value 1. However, with this alignment control, since the cross-over image is not an enlarged image at the position of the aperture, a fine position deviation, that is, an axial drift, may be not detected. As a result, a great position deviation may be produced in the enlarged cross-over image formed by a projecting lens arranged at a later stage, and a stable beam intensity cannot be obtained. Furthermore, when performing servocontrol for alignment, since the deflection center for alignment does not coincide with the beam shaping aperture position, the beam shape and the beam size may fluctuate. Since the alignment servo controller is constantly in operation, the deflecting system is adversely affected, and since the faraday cup for measuring the electron beam current is supported by an electrically insulative member in the electron optical column, the charges accumulated on this insulative member make the electron beam unstable.

As a matter of fact, in addition to the drift of the cross-over position as described above, there is a drift of the cross-over point position in the direction of the axis of the electron optical column when the cathode of the electron gun, e.g. formed of a LaB 6 tip, is heated for a long period of time and the shape of its front end changes, or when the electric power supplied for heating the electron gun changes. Since the deflecting center of a scanning deflector is generally set at the cross-over position, this type of drift gives rise to a change in the degree of deflection of the aperture image of the electron beam, and results in a variation of the size of the electron beam spot, and also in a deviation of the electron beam path when the beam size varies. Therefore, the conventional electron beam exposure systems do not form the shape and size of the electron beam spot in a precise and reliable manner.

It is an object of the present invention to provide an electron beam exposure system with which a circuit pattern may be correctly drawn with an electron beam and which is capable of correcting the deviation of the electron beam path which is caused by the axial drift of the cross-over position of the electron beam.

The present invention provides an electron beam exposure system comprising an electron gun for emitting an electron beam and in which the deviation of the electron beam path caused by an axial shift of the first cross-over of the electron beam is corrected, said system comprising:

— a first rectangular aperture for shaping the cross-section of the electron beam emitted from said electron gun into a rectangular shape;

— a condensor lens having a variable focal length for converging the electron beam to form a cross-over image;

— a second rectangular aperture onto which is projected the electron beam emerging from the cross-over image;

— a deflector interposed between said first and second apertures for deflecting the electron beam, said deflector defining a space in which a deflection center thereof and the cross-over image are located, and

— projecting means for projecting the electron beam onto a target plane to form a beam spot of rectangular shape by overlap of the images of said first and second apertures and to scan the electron beam on the target plane,

said electron beam exposure system being characterized by further comprising

— detecting means for detecting the fluctuations of the time that at least one of the sides of the rectangular beam spot needs to reach a detecting point after initiation of a scanning operation, and

— a central processing unit for comparing said fluctuations with values stored in a memory in order to allow selection of the focal length of the condensor lens and for supplying adequate instructions to a power source, thereby correcting the focal length of the condensor lens in order to correct the shape and size of the beam spot.

In an alternative, the present invention provides an electron beam exposure system comprising an electron gun for emitting an electron beam and in which the deviation of the electron beam path caused by an axial shift of the first cross-over of the electron beam is corrected, said system comprising:

— a first rectangular aperture for shaping the cross-section of the electron beam emitted from said electron gun into a predetermined shape;

— a condensor lens having a variable focal length for converging the electron beam passed through said first aperture to form a cross-over image;

— a second rectangular aperture onto which is projected the electron beam emerging from the cross–over image;

— a deflector interposed between said first and second apertures for deflecting the electron beam, said deflector defining a space in which a deflection center thereof and the cross-over image) are located and

— projecting means for projecting the electron beam passed through said second aperture onto a target plane to form a beam spot of rectangular shape by overlap of the images of said first and second apertures and to scan the electron beam on the target plane;

said electron beam exposure system being characterized by further comprising

— detecting means for detecting the fluctuations of the time that at least one of the sides of the rectangular beam spot needs to reach a detecting point after initiation of a scanning operation, and

— a central processing unit for comparing said fluctuations with values stored in a memory in order to allow selection of the deflection of the deflector and for supplying adequate instructions to a power source, thereby correcting the deflection of the deflector in order to corrent the shape and size of the beam spot.

When in the system according to the present invention, the cross-over position formed in the electron lens system drifts in the direction of the axis of the electron optical column, the deviation of the electron beam path caused by this drift can be corrected. When the electron beam is deflected by the beam spot shaping deflector interposed between the first and second apertures, the image of the first aperture is displaced, thereby varying the size and shape of the beam spot formed on the target plane by the overlap of both aperture images.

If the cross-over image is located at the deflection center of the spot shaping deflector, the locations of the two sides of the beam spot on the target plane defined by the second aperture image do not fluctuate. However, when the cross-over image is not located at the deflection center and the deflector operates, the locations of the two sides of the beam spot fluctuate. Thus, the focal length of a condenser lens is varied according to the location fluctuation of the two sides of the beam spot to form the cross-over image on the deflection center.

This invention can be more fully understood from the following detailed description when taken in conjunction with the accompanying drawings, in which:

Fig. 1 is a schematic view showing an electron beam exposure system according to an embodiment of the present invention; and

Figs. 2 and 3 are schematic perspective views showing a beam spot formed by the electron beam exposure system shown in Fig. 1.

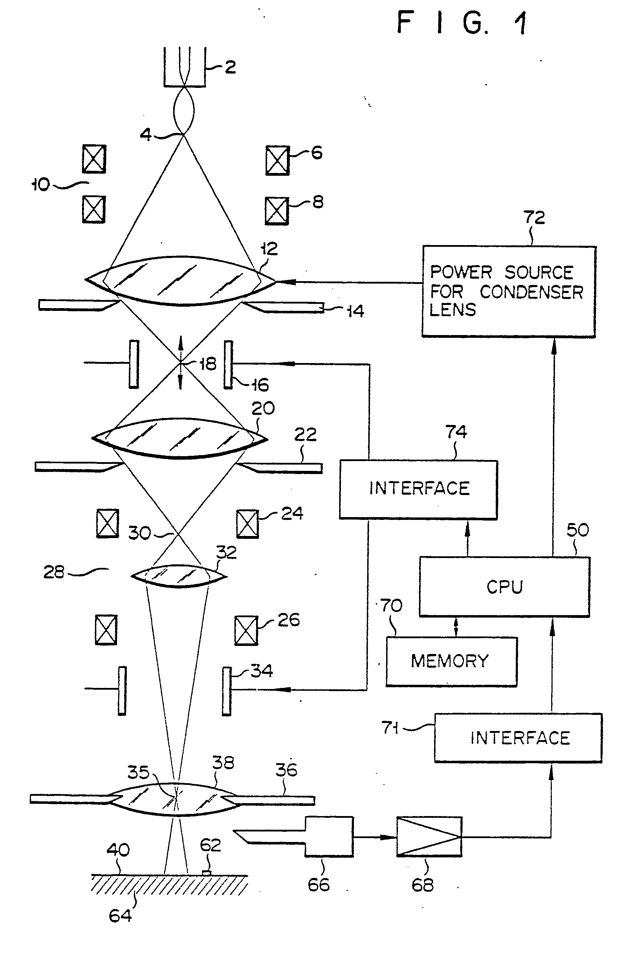

Fig. 1 is a schematic view showing an electron beam exposure system according to an embodiment of the present invention. An electron beam is emitted from an electron gun 2 having a cathode made of $LaB_6$. This electron beam forms a cross-over 4 and is directed towards a first condenser lens 12 through a space defined by a primary coil assembly 10 for initial alignment which includes first and second coils 6 and 8. The electron beam is focused by the first condenser lens 12, and passes through a first spot shaping square aperture 14 for shaping the electron beam into a square shape. The electron beam then forms a first cross-over image 18 in a space defined by a spot shaping deflector 16 for deflecting the electron beam. The electron beam emerging from the space within the spot shaping deflector 16 is focused by a second condenser lens 20 and is projected through a second spot shaping square aperture 22. Since the image formed by the first spot shaping aperture 14 is projected through the second spot shaping square aperture 22, a rectangular image formed by the superpositions of the images of both apertures 14 and 22 is formed by an electron lens system at the stage following the second spot shaping square aperture 22. The electron beam which has passed the second spot shaping square aperture 22 is guided to a space defined by an additional coil assembly 28 for additional alignment, the coil assembly 28 including third and fourth coils 24 and 26. The electron beam is focused in this space to a second cross-over image 30 and is projected by a demagnification lens 32. The electron beam converged by the lens 32 passes through a space defined by a spot scanning deflector 34 for deflecting the electron beam to scan a target 64 with a beam spot. The electron beam is guided to a projection lens 38 which is located at a third cross-over image 35 formed by the electron beam and which has an aperture 36 which is preferably larger than the cross-over image 35. The projection lens 38 forms on a target plane 40 the electron beam spot which is obtained by demagnification of the rectangular third image.

The target 64 has on its surface a detecting point 62 made of gold which reflects the electron beam. Above the detecting point 62 is located a reflective electron detector 66, such as a photodetector, which detects electrons or secondary electrons emitted from the detecting point 62. This detector 66 generates an electric signal upon reception of the electrons, which signal is amplified by an amplifier 68 to be supplied to a central processing unit (CPU) 50 through an interface 71. As will be described later, the CPU 50 supplies according to the data stored in a memory 70 a suitable instruction to a power source 72 to drive the condensor lens 12 and sets the focal length of the condensor lens 12 to a suitable value. The CPU 50 also may supply a voltage signal to the spot shaping deflector 16 and the spot scanning deflector 34 through an interface 74 so as to deflect the electron beam.

When the cross-over 4 of the electron beam drifts in the axial direction of the electron optical column, the deviation of the electron beam path caused by the drift is detected and corrected in a manner which is described in the following.

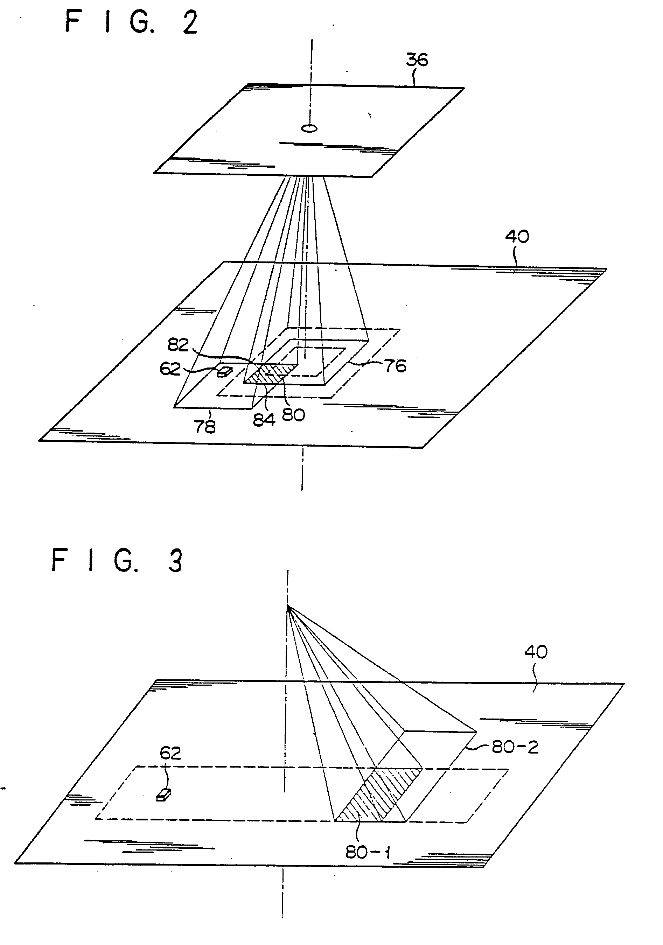

In general, when the cross-over 4 is correctly formed at the predetermined position so that the first cross-over point 18 is correctly formed at the deflection center of the spot shaping deflector 16, the size, shape and location of an image 76 of the second aperture 22 on the target plane 40 (Fig. 2) remain constant as long as the electron beam is not deflected by the spot scanning deflector 34. Although the image 76 is not actually formed on the target plane 40 in practice, it is shown figuratively at the target plane in Fig. 2. In contrast with this, with an image 78 of the first aperture 14 on the target plane 40, the size and shape do not generally change. However, when the electron beam is deflected by the spot shaping deflector 16, the location of the image 78 changes on the target plane 40 even if the electron beam is not deflected by the spot scanning deflector 34. As the image 76, the first aperture image 78 formed through the first aperture is not actually formed on the target plane, but is figuratively shown in Fig. 2. In practice, a rectangular image 80 formed by the overlap of the two images 76 and 78 indicated by hatched lines in Fig. 2 is actually projected on the target plane 40. Since the size, shape and location of the second aperture image 76 remain constant, unless the electron beam is deflected by the spot scanning deflector 26, the location of two sides 82 and 84 of the rectangular image 80 do not change. However, if the cross-over 4 drifts to cause the first cross-over image 18 to drift from the deflection center of the deflector 16 in the axial direction thereof independent of the action of the deflector, when the electron beam is deflected by the spot shaping deflector 16 and the location of the image 78 is changed, the second aperture image 76, which does not change under normal conditions, changes as shown by the broken line shown in Fig. 2. Thus, the locations of the two sides 82 and 84 of the rectangular image 80, which do not change under normal conditions, change. This has also been experimentally confirmed.

Considering the points described above, in the electron beam exposure system as shown in Fig. 1, the focal length of the condenser lens 12 is adjusted so that the locations of the two sides 82 and 84 of the square image 80 may not change even when the electron beam is deflected by the spot shaping deflector 16.

The memory 70 stores in advance data representing the relationship between the focal length and a time fluctuation related to the location change, which is obtained in the manner described below. The electron beam is first deflected a certain value by the spot shaping deflector 16 to form a rectangular image 80-1 of predetermined shape and size on the target plane 40 as shown in Fig. 3. This rectangular image 80-1 is deflected by the spot scanning deflector to scan the target plane 40 with the square image 80-1 as shown by the broken line in Fig. 3. When the detecting point 62 is scanned, the detector 66 detects electrons and generates a signal. The detecting point 62 is scanned by the rectangular image 80-1 to obtain a time interval from the initiation of the scanning operation to the detecting time of the detecting point 62 by the detector 66. The time intervals thus obtained are averaged to obtain time data for the rectangular image 80-1. Subsequently, the electron beam is deflected by the spot shaping deflector to vary the size and shape of the rectangular image 80-1 as shown in Fig. 3 to form a rectangular image 80-2. A time interval for the rectangular image 80-2 is also obtained in a similar manner. The time interval required for the side 82 of the rectangular image 80-1 to reach the detecting point 62, and the time interval required for the side 82 of the rectangular image 80-2 to reach the detecting point 62, remain constant under normal conditions. However, when the second cross-over image 18 is not correctly located at the deflection center of the deflector, their both time intervals vary. Such time fluctuations are recorded for the case wherein the focal length of the condenser lens 12 is changed by the power source 72. The relationship between the time fluctuation and the focal length of the condenser lens 12 which is required to compensate for such a time fluctuation is stored in the memory 70 in advance. Subsequently, prior to the exposure of the target 64 with the electron beam, unnecessary regions of the target 64 are scanned by the images 80-1 and 80-2 of different sizes, and time fluctuations are measured in the interface 71 and are supplied to the CPU 50. The CPU 50 selects the focal length of the condenser lens 12 corresponding to the particular time fluctuation from the data stored in the memory 70, and supplies an instruction corresponding to the focal length to the power source 72. As a result, the condenser lens 12 is driven by the power source 72 to have a predetermined focal length, so that the position of the first cross-over image 18 is corrected, and the circuit pattern may be drawn on the target 64 with the rectangular image of correct size and shape.

In place of the condenser lens 12, the size and shape of the square image 80 may be corrected by the spot shaping deflector 16 or the spot scanning deflector 34. If the size and shape of the image 80 do not match the correct size and shape due to the drift of the first cross-over image 18 when the size and shape of the square image 80 are changed, the size and shape of the image 80 may be corrected by the deflectors 16 and 34. For this purpose, the relationship between the error and correction amount is stored in the wave memory 70. In this case, the correction amount is obtained according to the detected error, and the CPU 50 may supply a suitable voltage signal to the deflectors 16 and 34 through the interface 74. Correction of the drift of the second cross-over point 18 with the deflectors 16 and 34 may be performed faster and with better response than the correction with the condenser lens 12.

In summary, according to the electron beam exposure system of the present invention, the error in the degree of deflection due to axial drift of the cross-over point, and errors in the precision of the size and shape of the beam spot of the scanning position may be effectively corrected. This allows an electron beam exposure of high precision when combined with conventional alignment control. According to the system of the present invention, the axial drift of the cross-over point may be automatically corrected by the feedback mechanism, and the system can thus be operated with excellent reliability.

## Claims

1. An electron beam exposure system comprising an electron gun (2) for emitting an electron beam and in which the deviation of the electron beam path caused by an axial shift of the first cross-over of the electron beam is corrected, said system comprising:
— a first rectangular aperture (14) for shaping the cross-section of the electron beam emitted from said electron gun (2) into a rectangular shape;
— a condensor lens (12) having a variable focal length for converging the electron beam to form a crossover image (18);
— a second rectangular aperture (22) onto which is projected the electron beam emerging from the crossover image (18);
— a deflector (16) interposed between said first and second apertures (14, 22) for deflecting the electron beam, said deflector (16) defining a space in which a deflection center thereof and the cross-over image (18) are located; and
— projecting means (36, 38, 34) for projecting the electron beam onto a target plane (40) to form a beam spot (80) of rectangular shape by overlap of the images (76, 78) of said first and second apertures (14, 22) and to scan the electron beam on the target plane,
characterized by further comprising
— detecting means (62, 66, 68, 71) for detecting the fluctuations of the time that at least one of the sides of the rectangular beam spot (80) needs to reach a detecting point (62) after initiation of a scanning operation, and
— a central processing unit (50) for comparing said fluctuations with values stored in a memory (70) in order to allow selection of the focal length of the condensor lens (12) and for supplying adequate instructions to a power source (72), thereby correcting the focal length of the condensor lens (12) in order to correct the shape and size of the beam spot (80).

2. An electron beam exposure system comprising an electron gun (2) for emitting an electron beam and in which the deviation of the electron beam path caused by an axial shift of the first cross-over of the electron beam is corrected, said system comprising:
— a first rectangular aperture (14) for shaping the cross-section of the electron beam emitted from said electron gun (2) into a predetermined shape;
— a condensor lens (12) having a variable focal length for converging the electron beam passed through said first aperture (14) to form a crossover image (18);
— a second rectangular aperture (22) onto which is projected the electron beam emerging from the crossover image (18);
— a deflector (16) interposed between said first and second apertures (14, 22) for deflecting the electron beam, said deflector (16) defining a space in which a deflection center thereof and the crossover image (18) are located; and
— projecting means (36, 38, 34) for projecting the electron beam passed through said second aperture (22) onto a target plane (40) to form a beam spot (80) of rectangular shape by overlap of the images (76, 78) of said first and second apertures (14, 22) and to scan the electron beam on the target plane,
characterized by further comprising
— detecting means (62, 66, 68, 71) for detecting the fluctuations of the time that at least one of the sides of the rectangular beam spot (80) needs to reach a detecting point (62) after initiation of a scanning operation, and
— a central processing unit (50) for comparing said fluctuations with values stored in a memory (70) in order to allow selection of the deflection of the deflector (16) and for supplying adequate instructions to a power source (72), thereby correcting the deflection of the deflector (16) in order to correct the shape and size of the beam spot (80).

3. A system according to claim 1, characterized in that said projecting means (36, 38, 34) includes a further deflector (34) for deflecting said electron beam to scan the target plane (40) with the beam spot (80).

4. A system according to claim 1 or 2, characterized in that said detecting point (62) is disposed on said target plane (40) and reflects electrons, in that said detecting means (62, 66, 68, 71) includes a detector (66) for detecting the electrons reflected by said detecting point (62).

5. A system according to claim 2, characterized in that said projecting means (36, 38, 34) includes scanning means (34) for scanning the target plane (40) with the beam spot (80).

6. A system according to claim 5, characterized in that said scanning means (34) is driven according to the fluctuation detected by said detecting means.

## Patentansprüche

1. System zur Betrahlung mit Elektronen bzw. Elektronenstrahl-Belichtungssystem mit einem Elektronenrohr oder Strahlerzeuger (2) zum Emittieren eines Elektronentrahls, bei dem die Abweichung der Elektronenstrahlstrecke, durch eine Axialverschiebung der ersten Überkreuzung des Elektronenstrahls hervorgerufen, korrigiert wird, umfassend

— eine erste Rechteckapertur (14) zum Formen des Querschnitts des vom Strahlerzeuger (2) emittierten Elektronenstrahls zu einer rechteckigen Form,

— eine Kondensorlinse (12) einer variablen Brennweite zum Konvergieren (Bündeln) des Elektronenstrahls zwecks Bildung eines Überkreuzungsbilds (18),

— eine zweite Rechteckapertur (22), auf die der aus dem Überkreuzungsbild austretende Elektronenstrahl projiziert wird,

— einen zwischen erste und zweite Apertur (14, 22) eingefügten Ablenker (16) zum Ablenken des Elektronenstrahls, wobei der Ablenker (16) einen Raum festlegt, in welchem ein Ablenkzentrum desselben und das Überkreuzungsbild (18) angeordnet sind, und

— eine Projektionseinrichtung (36, 38, 34) zum Projizieren des Elektronenstrahls auf eine Zielebene (40) zur Erzeugung eines Strahlflecks (80) einer rechteckigen Form durch Überlappung der Bilder (76, 78) von erster und zweiter Apertur (14, 22), und um den Elektronenstrahl die Zielebene abtasten zu lassen,
gekennzeichnet durch

— eine Detektoreinrichtung (62, 66, 68, 71) zur Erfassung der Schwankungen der Zeit zu welcher mindestens eine der Seiten des rechteckigen Strahlflecks (80) einen Meßpunkt (62) nach Einleitung eines Abtastvorgangs erreichen muß, und

— eine Zentraleinheit (50) zum Vergleichen der Schwankungen mit in einem Speicher (70) gespeicherten Größen zur Ermöglichung der Wahl einer Brennweite der Kondensorlinse (12) und zur Lieferung zweckmäßiger Anweisungen zu einer Stromquelle (72), um dabei die Brennweite der Kondensorlinse (12) zum Korrigieren von Form und Größe des Strahlflecks (80) zu korrigieren.

2. System zur Betrahlung mit Elektronen bzw. Elektronenstrahl-Belichtungssystem mit einem Elektronenrohr oder Strahlerzeuger (2) zum Emittieren eines Elektronentrahls, bei dem die Abweichung der Elektronenstrahlstrecke, durch eine Axialverschiebung der ersten Überkreuzung des Elektronenstrahls hervorgerufen, korrigiert wird, umfassend,

— eine erste Rechteckapertur (14) zum Formen des Querschnitts des vom Strahlerzeuger (2) emittierten Elektronenstrahls zu einer vorbestimmten Form,

— eine Kondensorlinse (12) variabler Brennweite zum Konvergieren des die erste Apertur (14) passierenden Elektronenstrahls zwecks Erzeugung eines Überzeugungsbilds (18),

— eine zweite Rechteckapertur (22), auf die der aus dem Überkreuzungsbild (18) austretende Elektronenstrahl projiziert wird,

— einen zwischen erste und zweite Apertur (14, 22) eingefügten Ablenker (16) zum Ablenken des Elektronenstrahls, wobei der Ablenker (16) einen Raum festlegt, in welchem ein Ablenkzentrum desselben und das Überkreuzungsbild (18) angeordnet sind, und

— eine Projektionseinrichtung (36, 38, 34) zum Projizieren des die zweite Apertur (22) passierenden Elektronenstrahls auf eine Zielebene (40) zur Erzeugung eines Strahlflecks (80) einer rechteckigen Form durch Überlappung der Bilder (76, 78) von erster und zweiter Apertur (14, 22), und um den Elektronenstrahl die Zielebene abtasten zu lassen,
gekennzeichnet durch

— eine Detektoreinrichtung (62, 66, 68, 71) zur Erfassung der Schwankungen der Zeit zu welcher mindestens eine der Seiten des rechteckigen Strahlflecks (80) einen Meßpunkt (62) nach Einleitung eines Abtastvorgangs erreichen muß, und

— eine Zentraleinheit (50) zum Vergleichen der Schwankungen mit in einem Speicher (70) gespeicherten Größen zur Ermöglichung der Wahl einer Ablenkung des Ablenkers (16) und zur Lieferung zweckmößiger Anweisungen zu einer Stromquelle (72), um dabei die Ablenkung des Ablenkers (16) zwecks Korrektur von Form und Größe des Strahlflecks (80) zu korrigieren.

3. System nach Anspruch 1, dadurch gekennzeichnet, daß die Projektionseinrichtung (36, 38, 34) einen weiteren Ablenker (34) zum Ablenken des Elektronenstrahls für die Abtastung der Zielebene (40) mit dem Strahlfleck (80) aufweist.

4. System nach Anspruch 1 oder 2, dadurch gekennzeichnet, daß der Meßpunkt (62) auf der Zielebene (40) angeordnet ist und Elektronen reflektiert und daß die Detektoreinrichtung (62, 66, 68, 71) einen Detektor (66) zum Erfassen der vom Meßpunkt (62) reflektierten Elektronen aufweist.

5. System nach Anspruch 2, dadurch gekennzeichnet, daß die Projektionseinrichtung (36, 38, 34) eine Abtasteinrichtung (34) zum Abtasten der Zielebene (40) mit dem Strahlfleck (80) aufweist.

6. System nach Anspruch 5, dadurch gekennzeichnet, daß die Abtasteinrichtung (34) nach Maßgabe von durch die Detektoreinrichtung erfaßten Schwankungen angesteuert wird.

## Revendications

1. Appareil d'exposition à un faisceau électronique comprenant un canon à électrons (2) servant à émettre un faisceau électronique et dans lequel la déviation du trajet du faisceau électronique provoquée par une dérive axiale du premier croisement du faisceau électronique est corrigée, ledit appareil comprenant:

une première ouverture rectangulaire (14) servant à donner à la section droite du faisceau électronique émis par ledit canon à électrons (2) une forme rectangulaire;

une lentille de condenseur (12) possédant une distance focale variable et servant à faire converger le faisceau électronique de manière à former une image de croisement (18);

une deuxième ouverture rectangulaire (22) sur laquelle est projeté le faisceau électronique sortant de l'image de croisement (18);

un déflecteur (16) placé entre lesdites première et deuxième ouvertures (14, 22) servant à faire dévier le faisceau électronique, ledit déflecteur (16) définissant un espace dans lequel une centre de déviation de celui-ci et l'image de croisement (18) sont placés; et

un moyen de projection (36, 38, 34) servant à projeter le faisceau électronique sur le plan d'une cible (40) afin de former une tache de faisceau (80) ayant une forme rectangulaire en faisant se chevaucher les images (76, 78) desdites première et deuxième ouvertures (14, 22) et de faire balayer par le faisceau électronique le plan de la cible;

caractérisé en ce qu'il comprend en outre:

un moyen de détection (62, 66, 68, 71) servant à détecter les fluctuations du temps qui est nécessaire pour qu'au moins un des côtés de la tache de faisceau rectangulaire (80) atteigne un point de détection (62) après le début d'une opération de balayage, et

une unité centrale de traitement (50) servant à comparer lesdites fluctuations avec des valeurs emmagasinées dans une mémoire (70) afin de permettre la sélection d'une distance focale de la lentille de condenseur (12) et servant à délivrer des instructions appropriées à une alimentation électrique (72), de manière à corriger la distance focale de la lentille de condenseur (12) pour corriger la forme et la taille de la tache (80) du faisceau.

2. Appareil d'exposition à un faisceau électronique comprenant un canon à électrons (2) servant à émettre un faisceau électronique et dans lequel la déviation du trajet du faisceau électronique provoquée par une dérive axiale du premier croisement du faisceau électronique est corrigée, ledit appareil comprenant:

une première ouverture rectangulaire (14) servant à donner à la section droite du faisceau électronique émis par ledit canon à électrons (2) une forme prédéterminée;

une lentille de condenseur (12) possédant une distance focale variable et servant à faire converger le faisceau électronique qui est passé dans ladite première ouverture (14) pour former une image de croisement (18);

une deuxième ouverture rectangulaire (22) sur laquelle est projeté le faisceau électronique sortant de l'image de croisement (18);

un déflecteur (16) placé entre lesdites première et deuxième ouvertures (14, 22) servant à faire dévier le faisceau électronique, ledit déflecteur (16) définissant un espace dans lequel un centre de déviation de celui-ci et l'image de croisement (18) sont placés; et

un moyen de projection (26, 38, 34) servant à projeter le faisceau électronique qui est passé dans ladite deuxième ouverture (22) sur le plan d'une cible (40) afin de former une tache de faisceau (80) ayant une forme rectangulaire en faisant se chevaucher les images (76, 78) desdites première et deuxième ouvertures (14, 22) et de faire balayer le plan de la cible par le faisceau électronique;

caractérisé en ce qu'il comprend en outre:

un moyen de détection (62, 66, 68, 71) servant à détecter les fluctuations du temps nécessaire pour qu'au moins un des côtés de la tache de faisceau rectangulaire (80) atteigne un point de détection (62) après le début d'une opération de balayage, et

une unité centrale de traitement (50) servant à comparer lesdites fluctuations avec des valeurs emmagasinées dans une mémoire (70) afin de permettre la sélection de la déviation du déflecteur (16) et servant à délivrer des instructions appropriées à une source d'alimentation électrique (72), de manière à corriger la déviation du déflecteur (16) pour corriger la forme et la taille de la tache de faisceau (80).

3. Appareil selon la revendication 1, caractérisé en ce que ledit moyen de projection (36, 38, 34) comporte un déflecteur supplémentaire (34) servant à dévier ledit faisceau électronique afin de faire balayer le plan de la cible (40) par la tache de faisceau (80).

4. Appareil selon la revendication 1 ou 2, caractérisé en ce que ledit point de détection (62) est disposé sur ledit plan de la cible (40) et réfléchit les électrons, et en ce que ledit moyen de détection (62, 66, 68, 71) comporte un détecteur (66) servant à détecter les électrons réfléchis par ledit point de détection (62).

5. Appareil selon la revendication 2, caractérisé en ce que ledit moyen de projection (36, 38, 34) comporte un moyen de balayage (34) servant à faire balayer le plan de la cible (40) par la tache de faisceau (80).

6. Appareil selon la revendication 5, caractérisé en ce que ledit moyen de balayage (34) est entraîné en fonction de la fluctuation détectée par ledit moyen de détection.

F I G. 1

0 049 872

# F I G. 2

36

40

82
62
76
78 84 80

# F I G. 3

40

62

80-2

80-1